# EUROPEAN PATENT APPLICATION

(11) **EP 0 646 948 A1**
(43) Date of publication of application: **05.04.1995**
(21) Application number: 94306992.2
(22) Date of filing: 26.09.1994
(51) Int. Cl.: H01L 21/00, B29C 45/02

(54) **Resin packaging method, and apparatus and mold for the same**

(30) Priority: 30.09.1993 JP 245483/93; 25.11.1993 JP 295105/93; 25.11.1993 JP 295106/93
(71) Applicant: TAMUSU TECHNOLOGY KABUSHIKI KAISHA, Kitakami-Shi, Iwate-Ken (JP)
(72) Inventor: Yonezu, Minetoshi, c/o Tamusu Technology K.K., Kitakami-shi, Iwate-Ken (JP); Sakamoto, Hideo, c/o Tamusu Technology K.K., Kitakami-shi, Iwate-ken (JP)
(74) Representative: Beresford, Keith Denis Lewis

(57) **Abstract**

A resin packaging method resin-packages a lead frame having predetermined electronic elements thereon such that the efficiency of utilization of a resin for resin packaging can be greatly improved, occurrence of defects, e.g., voids and chipping in the packaging portions, can be prevented, preheating of the resin is enabled, thus preventing early wear of components associated with supply of the resin, and the number of components to be replaced for alteration of the type of electronic elements to be resin-packaged can be largely decreased, thereby shortening the time required for replacement of a mold. This method includes the first step of preparing a thermosetting resin material to substantially match the inner shape of a runner elongated in a horizontal direction, the second step of positioning and holding the lead frame on upper surface portions of a plurality of cavities, which form female portions for resin packaging at substantially axial-symmetric positions thereof with respect to the longitudinal direction of the horizontally elongated runner through gates, the third step of flowing the thermosetting resin, the fourth step of simultaneously filling and feeding with pressure the thermosetting resin material toward the cavities by a movable runner.

## Description

### BACKGROUND OF THE INVENTION

The present invention relates to a resin packaging method, and an apparatus and a mold for the same, and more particularly, e.g., to a resin packaging method for resin-packaging, with a resin, a semi-completed product obtained by mounting predetermined electronic or electric elements, e.g., semiconductor elements and resistors, on, e.g., a lead frame, and an apparatus for the same.

Conventionally, various types of apparatuses are proposed that package, by using a thermosetting resin, a semi-completed product obtained by mounting semiconductor elements, resistors, and the like on a lead frame.

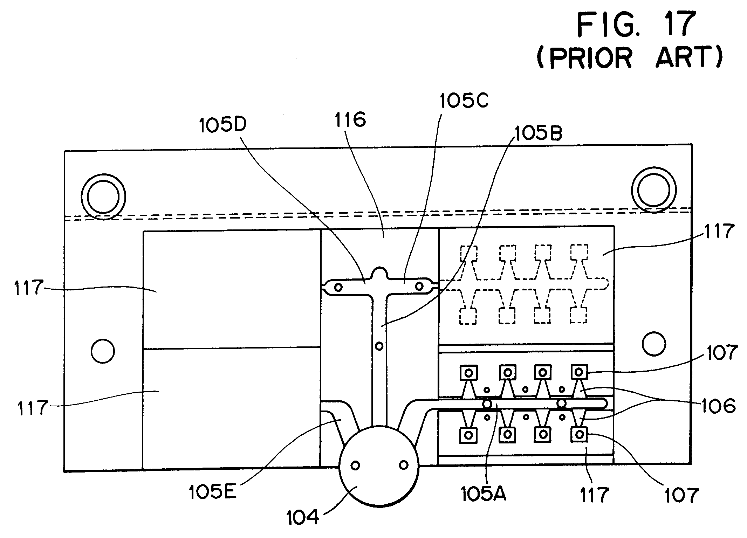

For example, Japanese Utility Model Laid-Open No. 56-30841 discloses an arrangement in which semiconductor elements are sealed or encapsulated with a resin. This proposal will be briefly described with reference to the accompanying drawing. Fig. 17 is a plan view of a mold seen from above its parting line, in which the mold is partially cut away along a plane extending along the parting line of the cavity.

Referring to Fig. 17, a material inlet portion called a pot 104, to which a preheated thermosetting resin, e.g., an epoxy resin is supplied, is formed at the central portion of the upper die. One plunger (not shown) having a large size is movably provided in the pot 104. When the plunger performs a pressing operation, the thermosetting resin is supplied to runners 105A to 105E communicating with the pot 104 and into cavities 107 through gates 106 formed to branch to the right and left from longitudinal portions of each runner. A plurality of cavities 107 are formed in each cavity block 117, as shown in Fig. 17.

In the above arrangement, lead frames, on which predetermined electronic elements have been mounted, are positioned and set on a lead frame mounting portion provided on the parting line of the mold, and the mold is closed. Thereafter, a preheated thermosetting resin, e.g., an epoxy resin, is pressed into the pot 104 with the plunger, thereby supplying the thermosetting resin into the cavities 107 through the respective runners. Then, after the resin is hardened, the mold is opened. Portions of the cavities 107 and the respective runners 105A to 105E indicated by hollow circles are pressed with ejector pins (not shown), so that an integral product of a cull portion hardened in the pot 104, the runner portions hardened in the respective runners 105A to 105E, and package portions hardened in the cavities 107 to contain the lead frames is extracted from the mold. In this manner, resin packaging for so-called multi-cavity molding is performed.

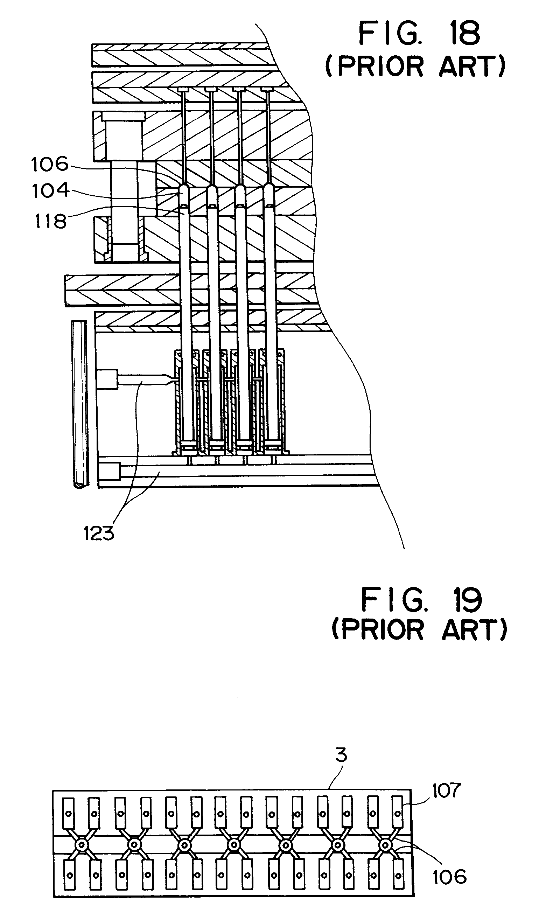

Japanese Utility Model Laid-Open No. 57-53324 discloses an arrangement in which a resin is directly supplied into cavities in order to seal semiconductor elements with the resin. Fig. 18 is a main-part sectional view obtained by cutting away the arrangement of this proposal along a plane extending along pots 104, and Fig. 19 is a plan view of the mold of Fig. 18 seen from a plane extending along the parting line. Referring to Fig. 19, two sets of cavities 107 are formed in right and left cavity blocks, and the respective cavity blocks are arranged in the mold to oppose each other. Gates 106 communicating with the respective cavities are radially provided at the intermediate portions of the cavities 107. Pots 104 having a small size are located at portions where the gates 106 are concentrated, as shown in Fig. 18. Plungers 118 are individually driven upward and downward in the respective pots 104 by hydraulic units 123. In the above arrangement, lead frames having semiconductor elements mounted therein are set at predetermined positions on the parting line between the upper and lower dies, a non-heated thermosetting resin, e.g., an epoxy resin, is supplied into the pots 104, and the mold is closed. Thereafter, a thermosetting resin material obtained by pressing this molding compound in the pots 104 with the plungers 118 to a plastic state is injected into the cavities 107 with pressure through the gates 106, thereby molding the molding component to seal the semiconductor elements.

### SUMMARY OF THE INVENTION

In the former technique in the above description, the molding material used for resin packaging is extracted from the mold in a state wherein the package portions molded in the cavities 107, the cull portion molded in the pot 104, the runner portions molded in the respective runners 105A to 105E, and the gate portions molded in the respective gates 106 are integrated. Thus, the efficiency of utilization of the molding material which is equal to the ratio of the amount of resin used for resin packaging to the total resin consumption amount becomes 20% or less. Also, the molding material for resin packaging is thermosetting. Therefore, it is pointed out that it is impossible to re-utilize the molding compound by milling, like a thermoplastic resin, and all the cull portions and the runner portions must be wasted, which is not economical.

Furthermore, according to this proposal, since the resin flows from the outer periphery of the pot 104 toward the respective runners, a time difference of about 5 seconds sometimes occurs between a time point at which the resin first enters the cavity 107 closest to the pot 104 and a time point at which the resin enters the cavity 107 farthest from the pot 104. As a result, the overall supply of the resin to the cavities 107 becomes non-uniform, and a molding defect, e.g., a void, occurs in the resin package, causing a decrease in yield.

According to the latter proposal, as the cavities 107 are arranged substantially radially about each cylindrical pot 104 as the center, the resin is supplied into the cavities substantially uniformly, so that an inconvenience of occurrence of, e.g., voids, in the resin package portions are eliminated. In this proposal, however, since the number of cavities 107 of each pot 104 is as small as four, the amount of resin used is also small accordingly, and thus the heat capacity of the resin is also small. When the amount of resin is small, handling becomes difficult, so that the resin cannot be sufficiently preheated. Thus, the resin still in a hard state is pushed in the pots 104 with the plungers 118 toward the cavities 107, increasing friction between the pots 104 and the plungers 118. As a result, the life of each component becomes about 1/3 that of the former proposal, and the cost of maintenance required for replacement of components becomes considerably large.

When the cavity block and the like are to be replaced for altering the type of electronic elements to be resin-packaged, since the pots communicating with the cavities are separately provided, the number of components to be replaced becomes very large, and thus the time required for replacement and the cost of components are increased.

A resin packaging method and an apparatus for the same according to the present invention have been made in view of the above problems. It is a concern of the present invention to provide a resin packaging method wherein the efficiency of utilization of a resin for resin packaging can be greatly improved, occurrence of defects, e.g., voids and chipping in the packaging portions can be prevented, preheating of the resin is enabled, thus preventing early wear of components associated with supply of the resin, and the number of components to be replaced for alteration of the type of electronic elements to be resin-packaged can be largely decreased, thereby shortening the time required for replacement of a mold; and an apparatus for the same.

It is another concern of the present invention to provide a resin packaging method wherein, when preparing a thermosetting material to be flowed into the runner of a press unit in order to perform resin packaging in which occurrence of defects, e.g., voids and chipping in the resin packaging portions, can be prevented, waste of the material to be used can be eliminated; and an apparatus for the same.

In addition, it is still another concern of the present invention to appropriately prepare a thermosetting material having optimum volume and shape to cope with alteration of the type of electronic elements to be resin-packaged.

It is still another concern of the present invention to provide a die set which can be disassembled easily, is inexpensive, and has an excellent heat stability for the purpose of molding a thermosetting material.

It is still another concern of the present invention to provide a resin packaging mold unit wherein the efficiency of utilization of a resin for resin packaging can be greatly improved, occurrence of defects, e.g., voids and chipping in the packaging portions, can be prevented, preheating of the resin is enabled, thus preventing early wear of components associated with supply of the resin, and the number of components to be replaced for alteration of the type of electronic elements to be resin-packaged can be largely decreased, thereby shortening the time required for replacement of a mold.

According to the present invention, there is provided a resin packaging method for resin-packaging a lead frame having predetermined electronic elements mounted thereon, comprising the first step of preparing a thermosetting resin material molded to have a predetermined volume to substantially match an inner shape of a runner elongated in a horizontal direction, the second step of, after mold opening, positioning and holding the lead frame on upper surface portions of a plurality of cavities, which form female portions for resin packaging at substantially axial-symmetric positions thereof with respect to a longitudinal direction of the horizontally elongated runner through gates, the third step of flowing the thermosetting resin material into the horizontally elongated runner, the fourth step of, after mold closing, simultaneously filling and feeding with pressure the thermosetting resin material toward the cavities by a movable runner which is driven in the horizontally elongated runner, thereby performing resin packaging, and the fifth step of, after mold opening, extracting an integral product of the lead frame which has been resin-packaged.

According to the present invention, there is also provided a resin packaging apparatus for resin-packaging a lead frame having predetermined electronic elements mounted thereon, comprising a plurality of cavities which form female portions for resin packaging at substantially axial-symmetric positions thereof with respect to a longitudinal direction of a horizontally elongated runner through gates, and a movable runner for simultaneously filling and feeding with pressure a thermosetting resin material, pre-molded to substantially match an inner shape of the horizontally elongated runner, toward the cavities through the horizontally elongated runner.

With the above arrangement, the thermosetting resin material flowed in the horizontally elongated runner is uniformly supplied into the respective cavities through the gates by the pressing operation of the movable runner. Also, the replacement operation of the cavity block forming the cavities therein is simplified.

According to the present invention, there is also provided a resin packaging method for resin-packaging a lead frame having predetermined electronic elements mounted thereon, comprising, in order to prepare a thermosetting resin material molded to have a predetermined volume and a predetermined shape to substantially match an inner shape of a horizontally elongated runner, the first step of supplying a granular material substantially uniformly toward a die set having a hollow portion substantially matching the inner shape of the horizontally elongated runner, the second step of compression-molding the material, supplied into the die set, with a punch, thereby obtaining the thermosetting resin material, the third step of extracting the thermosetting resin material, after the die set is mold-opened, and flowing the thermosetting resin material into the horizontally elongated runner, the fourth step of simultaneously filling and feeding with pressure the thermosetting resin material toward cavities by a movable runner which is driven in the horizontally elongated runner, thereby performing resin packaging after a press unit for resin packaging performs mold closing, and the fifth step of extracting an integral product, which has been resin-packaged, after the press unit performs mold opening, to outside the mold.

According to the present invention, there is also provided a resin packaging apparatus for resin-packaging a lead frame having predetermined electronic elements mounted thereon, comprising, in order to prepare a thermosetting resin material molded to have a predetermined volume and a predetermined shape to substantially match an inner shape of a horizontally elongated runner, material supplying means for supplying a granular material substantially uniformly toward a die set having a hollow portion substantially matching the inner shape of the horizontally elongated runner, compression molding means for compression-molding the material, supplied into the die set, with a punch, thereby obtaining the thermosetting resin material, conveying means for extracting the thermosetting resin material, after the die set is mold-opened, and conveying and flowing the thermosetting resin material into the horizontally elongated runner, a press unit for simultaneously filling and feeding with pressure the thermosetting resin material toward cavities by a movable runner which is driven in the horizontally elongated runner, thereby performing resin packaging after the press unit for resin packaging performs mold closing, and extracting means for extracting an integral product, which has been resin-packaged, after the press unit performs mold opening, to outside the mold.

With the above arrangement, when the thermosetting material, which is to be formed to have such a shape that it can be flowed into the horizontally elongated runner of the press unit and to be uniformly supplied into the respective cavities through the gates by the pressure operation of the movable runner, is prepared, a waste in the material to be used can be eliminated, thereby appropriately preparing a thermosetting material having optimum volume and shape to cope with alteration of the type of electronic elements to be resin-packaged. Also, a die set used for molding the thermosetting material can be made to be disassembled easily, to be inexpensive, and to have an excellent heat stability.

According to the present invention, there is also provided a resin packaging mold unit for resin-packaging a lead frame having predetermined electronic elements mounted thereon, comprising a press unit main body, a cavity block which is fixed to the press unit main body to be easily detachable and forms a plurality of cavities for resin packaging at substantially axial-symmetric positions with respect to an elongated direction of a horizontally elongated runner through gates, a movable runner for supplying a thermosetting resin material, pre-molded to have a shape substantially matching an inner circumferential shape of the horizontally elongated runner, into the cavities, a drive runner, disposed on the press unit main body to be movable in a parallel manner in order to reciprocally drive the movable runner, and having an engaging portion for allowing one-step insertion of the movable runner therein, thereby detachably fixing the movable runner therein, and drive means, disposed on the press unit main body, for moving the drive runner in the parallel manner.

According to the present invention, there is also provided a resin packaging mold unit for resin-packaging a lead frame having predetermined electronic elements mounted thereon, comprising a press unit main body having a stationary base and a movable base, a first cavity block which is fixed to the movable base to be easily detachable and forms a plurality of cavities for resin packaging at substantially axial-symmetric positions with respect to an elongated direction of a horizontally elongated runner through gates, a second cavity block which is fixed to the stationary base to be easily detachable and forms a plurality of cavities for resin packaging, a movable runner for supplying a thermosetting resin material, pre-molded to have a shape substantially matching an inner circumferential shape of the horizontally elongated runner, into the cavities, a drive runner, disposed on the press unit main body to be movable in a parallel manner in order to move the movable runner, and having an engaging portion for allowing insertion of the movable runner therein in a longitudinal direction thereof, thereby detachably fixing the movable runner therein, and drive means, disposed on the movable base of the press unit main body, for moving the drive runner in the parallel manner.

With the above arrangement, the thermosetting resin material flowed into the horizontally elongated runner is uniformly supplied into the respective cavities through the gates by the reciprocal movement of the movable runner. Also, when the cavity blocks each forming cavities are to be replaced, the movable runner can be easily replaced.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

Fig. 1 is a sectional view showing the main part of a resin packaging apparatus according to an embodiment of the present invention;
Fig. 2 is a plan view of the cavity block of the first embodiment;
Fig. 3 is a sectional view showing resin packaging in a mold-open state;
Fig. 4 is a sectional view showing resin packaging in a mold-closed state;
Fig. 5 is a sectional view showing a state wherein filling of resin packaging is completed in a mold-closed state;
Fig. 6 is a perspective view showing the outer appearance of semi-completed products after resin packaging;
Fig. 7 is a perspective view showing the outer appearance of other semi-completed products after resin packaging;
Fig. 8 is a perspective view showing the outer appearance of a thermosetting resin material manufacturing unit Q;
Fig. 9 is a perspective view showing the outer appearance of a thermosetting resin material convey unit R;
Fig. 10A is a sectional view, taken along the line X - X of Fig. 8, of a die set for arbitrarily molding a thermosetting resin 19 to have a desired cross-sectional shape;
Fig. 10B is a sectional view, taken along the line X - X of Fig. 8, of the die set for arbitrarily molding the thermosetting resin 19 to have a desired cross-sectional shape;
Fig. 11A is a plan view showing the closed state of the die set;
Fig. 11B is a plan view showing the open state of the die set;
Fig. 12 is a sectional view of the main part of a resin packaging mold unit;
Fig. 13 is a perspective view showing the outer appearance of a drive mechanism for a drive runner 71;
Fig. 14 is a perspective view showing the outer appearance of the drive mechanism for the drive runner 71 in order to explain the operation thereof;
Fig. 15A is a side view of a drive runner and a movable runner;
Fig. 15B is a side view of another drive runner and another movable runner;
Fig. 16 is a view showing the overall arrangement of the resin packaging apparatus;
Fig. 17 is a plan view of a conventional mold seen from its parting line;
Fig. 18 is a sectional view of the main part of another conventional mold; and
Fig. 19 is a plan view of the conventional mold of Fig. 18 seen from its parting line.

It is to be understood that the present invention is not limited to the embodiments to be described later and the accompanying drawings but includes various other arrangements defined in the scope of the claims.

### DETAILED DESCRIPTION OF THE PREFERRED EMBODIMENTS

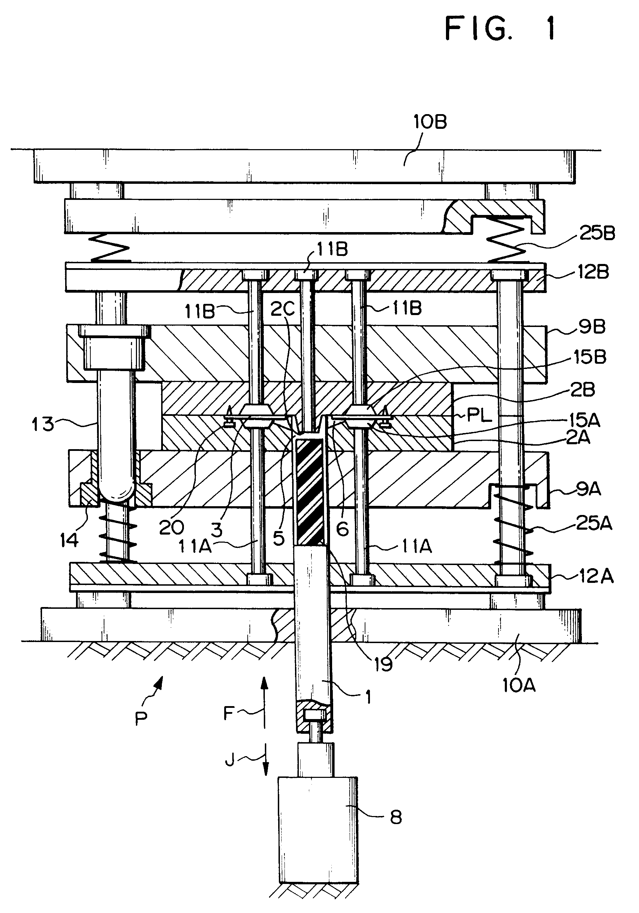

The preferred embodiments of the present invention will be described with reference to the accompanying drawings. Fig. 1 is a cutaway view showing the main part of a resin packaging apparatus, in which the common arrangement of the respective embodiments is shown. Referring to Fig. 1, constituent portions respectively indicated by reference numerals each with suffix B and associated with the upper mold, and constituent portions respectively indicated by reference numerals each with suffix A and associated with the lower mold, are provided at predetermined positions of the press unit, as shown in Fig. 1. When a press unit P is open, the constituent portions of the upper and lower molds are separated from each other at a parting line PL formed between upper and lower cavity blocks 2B and 2A.

Cavities 15B and 15A for molding resin packages are formed in the upper and lower cavity blocks 2B and 2A, provided to be separable from each other at the parting line PL as the boundary plane, in the manner to be described later. The upper and lower cavity blocks 2B and 2A are fixed to upper and lower backup plates 9B and 9A that respectively position the upper and lower cavity blocks 2B and 2A. The upper and lower backup plates 9B and 9A are positioned with respect to each other by guides 13 fixed to the upper backup plate 9B and bushes 14 provided to the lower backup plate 9A.

Ejector pins 11B for pushing out the packages molded in the upper cavities 15B and a runner 5 from the upper cavity block 2B to the outer side obtain the pushout force from the movement of an upper ejector pin receptacle base 12B that holds the ejector pins 11B. Ejector pins 11A for pushing out the packages molded in the lower cavities 15A from the upper cavity block 2A to the outside obtain the pushout force from the movement of a lower ejector pin receptacle base 12A that holds the ejector pins 11A.

The upper and lower ejector pin receptacle bases 12B and 12A are moved by the pressing force obtained during the opening operation of the press unit P using upper and lower springs 25B and 25A. The mold having the above arrangement is mounted to the press unit P through upper and lower bases 10B and 10A.

Gates 6 are formed among the lower cavities 15A of the lower cavity block 2A to communicate with the runner 5. A movable runner 1 is provided under the runner 5 to be movable in directions indicated by arrows F and J in Fig. 1 upon being driven by an actuator 8.

The movable runner 1 is not limited to have a conventional cylindrical shape, and is formed to be, e.g., rectangularly by considering the layout of the cavities.

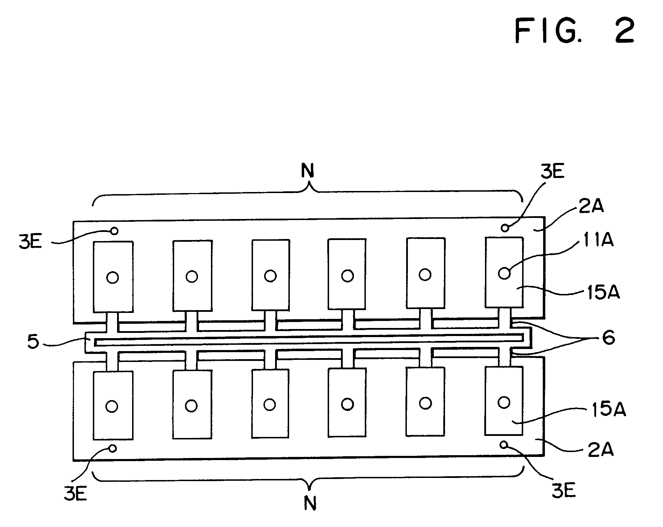

Fig. 2 is a plan view of the lower cavity block 2A seen from the parting line PL shown in Fig. 1 and shows an arrangement of the lower cavities 15A, which is the most characteristic feature of the present invention. More specifically, referring to Fig. 2, N lower cavities 15A are formed along the longitudinal direction of the lower cavity block 2A such that they communicate with the horizontally elongated runner 5 through the gates 6 communicating with the respective lower cavities 15A. A resin material having a sectional shape close to the outer shape of the runner 5 and to be flowed into the movable runner 1 is located under the runner 5 provided in this manner. Positioning pins 20 to be inserted into positioning holes 3E, formed in lead frames 3, thereby positioning the lead frames 3 with respect to the cavity blocks, are provided to the lower cavity block 2A. The upper cavities 15B are formed in the upper cavity block 2B at positions opposing the lower cavities 15A, and a convex portion 2C is molded at a position of the lower cavity block 2A opposing the runner 5, as shown in Fig. 1. The corresponding ejector pin 11B moves through the convex portion 2C to push out the convex portion 2C molded in the runner 5.

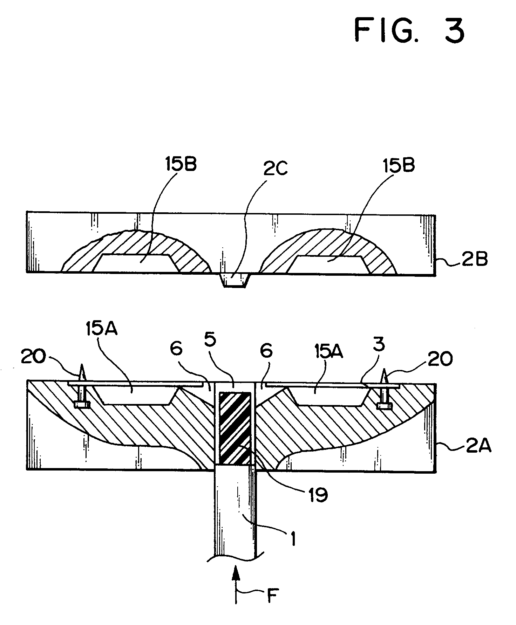

The operation of the arrangement of the above description will be described with reference to Figs. 3 to 5 that explain the operation. First, the mold is opened to have a state shown in Fig. 3. At this time, the movable runner 1 is withdrawn in the runner 5 due to the operation of the actuator 8 so that a thermosetting resin 19 can be flowed. Hence, the thermosetting resin 19 is automatically flowed. Almost simultaneously with this operation, the lead frames 3 are set with respect to the positioning pins 20, provided to the lower cavity block 2A, by using a chucking hand unit (not shown). Then, the upper cavity block 2B is mold-closed such that it mates with the lower cavity block 2A at the parting line PL.

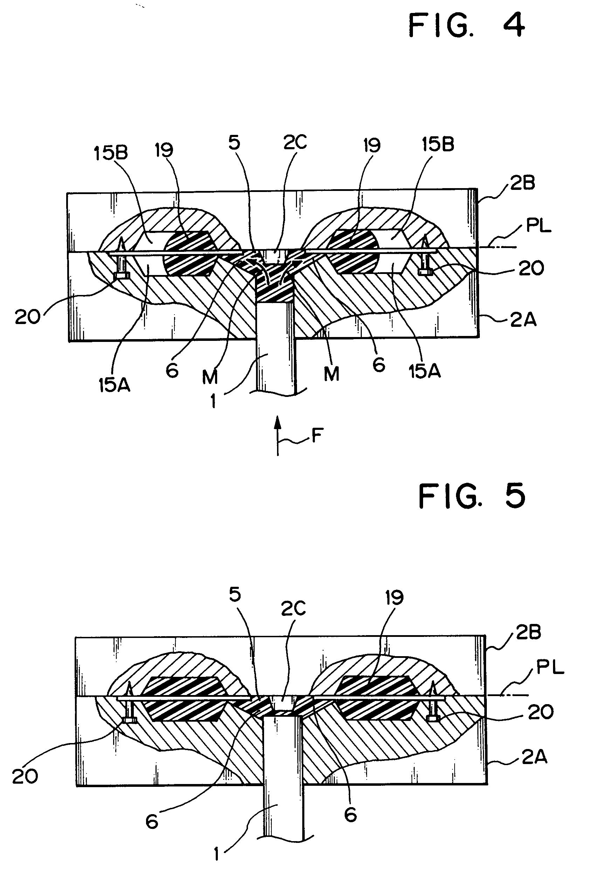

Thereafter, as shown in Fig. 4, the movable runner 1 is driven in the direction of an arrow F by the operation of the actuator 8, so that the thermosetting resin 19 is gradually guided into the upper and lower cavities 15B and 15A in directions indicated by arrows M through the gates 6. When resin filling into the upper and lower cavities 15B and 15A is completed, as shown in Fig. 5, the movable runner 1 is stopped at the final position.

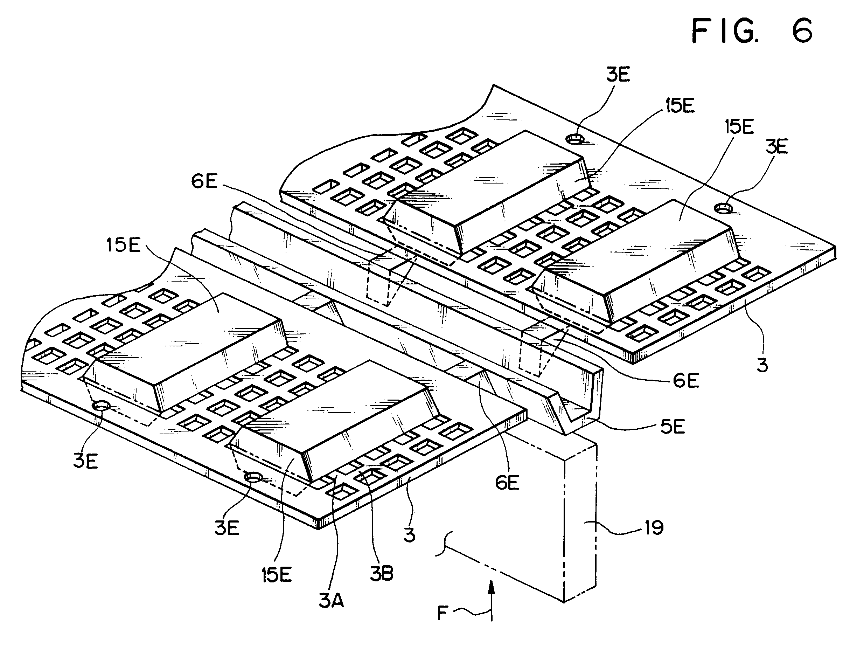

The press unit P is opened to remove the mold. The resin package portions are ejected from the cavities 15B and 15A by the pushout movement of the respective ejector pins 11B and 11A, held by the chucking hand, and extracted from the mold. Fig. 6 is a perspective view showing the outer appearance of semi-completed products obtained through the respective steps of the above description. Referring to Fig. 6, the thermosetting resin 19 to be moved with pressure in a direction indicated by an arrow F is indicated by an alternate long and two short dashes line. As is apparent from Fig. 6, the thermosetting resin 19 is pre-molded to have a shape matching the bottom surface of a runner forming portion 5E. Thus, as the movable runner 1 is moved upward, the thermosetting resin 19 can move substantially uniformly in the runner 5 toward the cavities through the gates 6. Resin package portions 15E are molded on the upper and lower surfaces of the lead frames 3 as shown in Fig. 6. Gate forming portions 6E are formed to be continuous with the runner forming portion 5E only in the resin package portions 15E formed on the lower surfaces of the lead frames 3. Thus, a semi-completed integral product can be obtained. Thereafter, these semi-completed products are set in the press unit (not shown) with respect to the positioning holes 3E as a reference. Bridge portions 3B of the lead frames 3 are cut away to leave lead portions 3A, and the lead portions 3A are bent in accordance with a predetermined manner, thereby obtaining completed products.

It is preferable to use a common movable runner 1 to cope with a case wherein the type of the electronic elements to be resin-packaged is altered and resin packaging is to be performed by using cavities having different shapes. By this arrangement, when compared with the proposal disclosed in Japanese Utility Model Laid-Open No. 57-53324 described above, replacement of the multipots 117, the multiplungers 118, the hydraulic units 123, and the like becomes unnecessary. Thus, the number of components to be replaced for alteration of the type of the electronic elements is largely decreased, and that the time required for replacement of the mold can be shortened. Therefore, this arrangement is optimum for production of a large number of types of electronic elements with small lots.

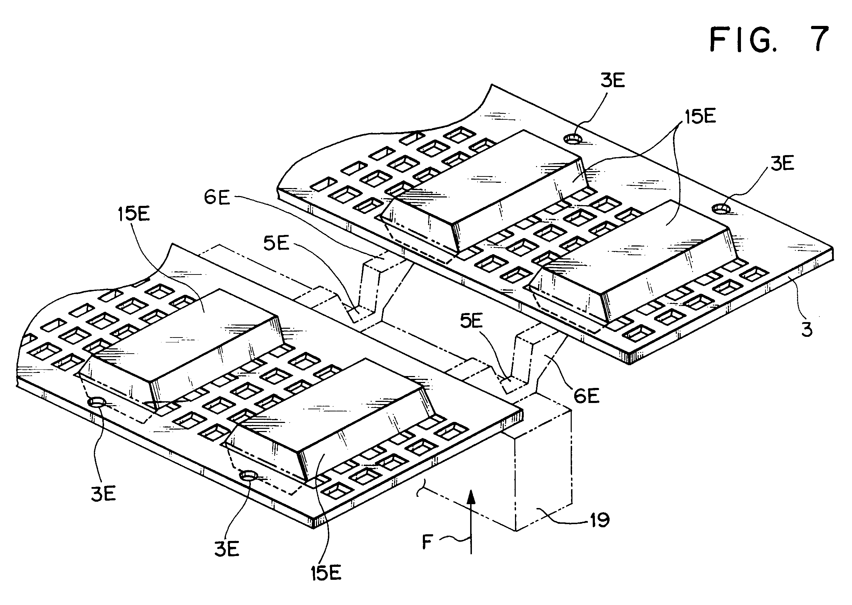

Fig. 7 is a perspective view (seen from a lower surface) showing sealed products according to the second embodiment of the present invention, in which the push-in operation of a thermosetting resin 19 with a movable runner 1 is completed. In this embodiment, portions of the runner excluding the gates opposite the movable runner 1 have slidable projecting shapes. Since these projecting portions are withdrawn as they are pushed by the movable runner 1, the amount of resin between the gates is further decreased, so that a further increase in efficiency of use of the resin can be achieved. Therefore, the thermosetting resin 19 is separately supplied into the cavities by the movable runner 1.

As described above, since the volume of the runner forming portions 5E is largely decreased, the efficiency of utilization of the resin is increased to twice or more. No time difference occurs between the filling operations of the thermosetting resin 19 into the cavities, and the thermosetting resin 19 is simultaneously filled into all the cavities. Thus, voids and the like do not occur, increasing the yield. Since the size of the movable runner 1 can be set large, the resin can be preheated. Accordingly, a resin in a soft state can be filled into the cavities through the runner and the gates, decreasing friction of the mold. Since the number of components to be replaced for alteration of the type of electronic elements is largely decreased, the cost of components is decreased, and the time required for replacement of the components can be decreased to about 1/5 that of a conventional apparatus.

As described above, according to the present invention, there is provided a resin packaging method wherein the efficiency of utilization of a resin for resin packaging can be greatly improved, occurrence of defects, e.g., voids and chipping in the packaging portions can be prevented, preheating of the resin is enabled by means of molding the packaging resin rectangularly to have a wide surface area, thus preventing early wear of components associated with supply of the resin, and the number of components to be replaced for alteration of the type of electronic elements to be resin-packaged can be largely decreased, thereby shortening a time required for replacement of a mold; and an apparatus for the same.

Preparatory steps for preparing the thermosetting resin 19 described above to substantially match the shape of the runner 5 will be described.

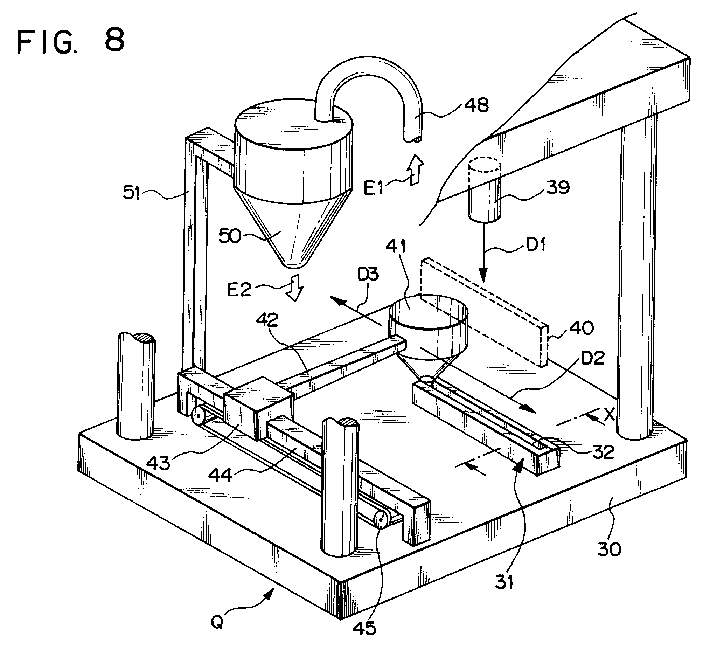

Fig. 8 is a perspective view showing the outer appearance of a thermosetting resin manufacturing unit Q, which is partially cut away to show its main part. Referring to Fig. 8, a die set 31 having a rectangular opening 32, as shown in Fig. 8, is fixed on a base 30 serving as the base portion of the unit Q. Necessary amounts of a granular epoxy resin and a compound material both serving as the material to form the thermosetting resin 19 described above are supplied through the opening 32 of the die set 31.

After the necessary amounts of the epoxy resin and the compound material are supplied into the die set 31, a punch 40 indicated by broken lines in Fig. 8 is moved by the operation of a punch hydraulic cylinder 39 in a direction indicated by an arrow D1 toward the opening 32 of the die set 31, to compress the granular epoxy resin and the predetermined compound material in the die set 31. As a result, the thermosetting resin 19 hardened to have a desired shape is molded in the die set 31. In order to supply the necessary amounts of the epoxy resin and the compound material into the die set 31 in the manner as described above, the granular epoxy resin and the predetermined compound material are supplied in advance into a hopper 50 through a hopper pipe 48 in a direction indicated by an arrow E1 in Fig. 8. The hopper 50 is fixed on the base 30 through an arm 51 shown in Fig 8. When an opening/closing valve (not shown) provided below the hopper 50 is opened/closed, predetermined amounts of the granular epoxy resin and the predetermined compound material are dropped by gravity in a direction indicated by an arrow E2, and are temporarily stored in a supply unit 41 provided below the hopper 50 to be movable in directions indicated by arrows D2 and D3.

An arm 42 having the one end fixed to a carriage 43 is fixed to the supply unit 41. As the carriage 43 is driven by carriage motors 45 in a predetermined manner to move on a guide rail 44 in the direction indicated by the arrow D2, the granular epoxy resin and the predetermined compound material are uniformly supplied from the supply unit 41, through its open hole 41a at its lower portion, into the die set 31, through its opening 32.

When it is difficult to uniformly supply the granular epoxy resin and the predetermined compound material into the die set 31 only by the effect of gravity in this manner, a squeezer may be provided in the vicinity of the open hole 41a of the supply unit 41, and excess amounts of the materials at the opening 32 may be removed thereby. Alternatively, small vibrations may be given to the supply unit 41, so that predetermined amounts of the granular epoxy resin and the predetermined compound material may be constantly dropped.

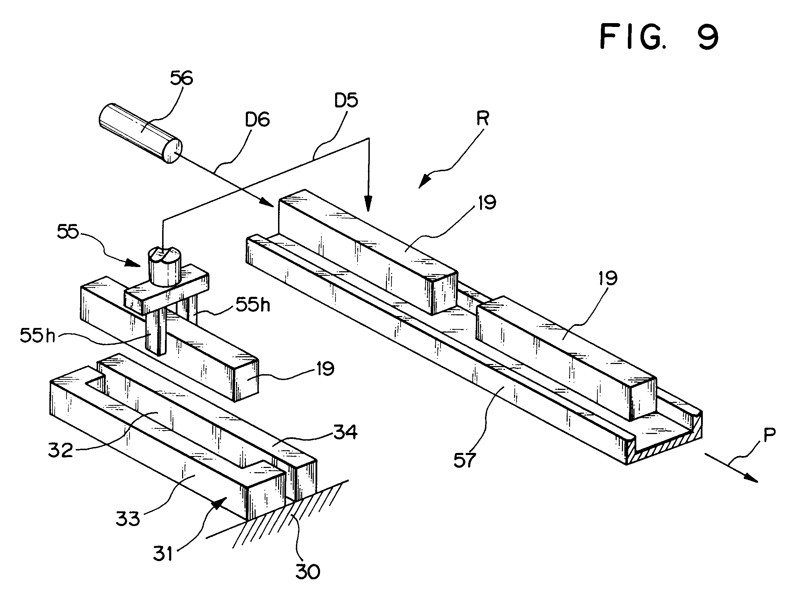

Fig. 9 is a view showing the outer appearance of a convey unit R that extracts the completed molded thermosetting resin 19 from the die set 31 and conveys it to the press unit P described above.

Referring to Fig. 9, when the thermosetting resin 19 is molded into a predetermined shape in the die set 31 provided on the base 30 by the moving compression operation of the punch 40, a movable die 34 of the die set 31 moves to open its opening 32 in the widthwise direction, so that holding portions 55h of a robot hand 55 can enter the opening 32 of the die set 31 between the movable and stationary dies 34 and 33. Thereafter, the holding portions 55h of the robot hand 55 move downward into the opening 32 of the die set 31, holds the thermosetting resin 19, and move upward to temporarily extract it from the die set 31. Then, the holding portions 55h convey the thermosetting resin 19 in a direction of an arrow D5 in Fig. 9, such that the thermosetting resin 19 is held by the holding portions 55h of the robot hand 55, and place the thermosetting resin 19 on a guide 57 having a cross-sectional shape to prevent dropping, as shown in Fig. 9.

In this manner, the thermosetting resin 19 placed on the guide 57 is pushed by using a cylinder 56 in a direction indicated by an arrow D6 in Fig. 9, so that it is conveyed to the runner 5 of the press unit P.

When the thermosetting resin manufacturing and convey units are disposed on the upstream side of the press unit P, a series of units for continuously supplying the thermosetting resins 19 having desired shapes can be constituted. As a result, the volume of the runner forming portion can be largely decreased, and the efficiency of utilization of the thermosetting resin material and the compound can be increased to twice or more.

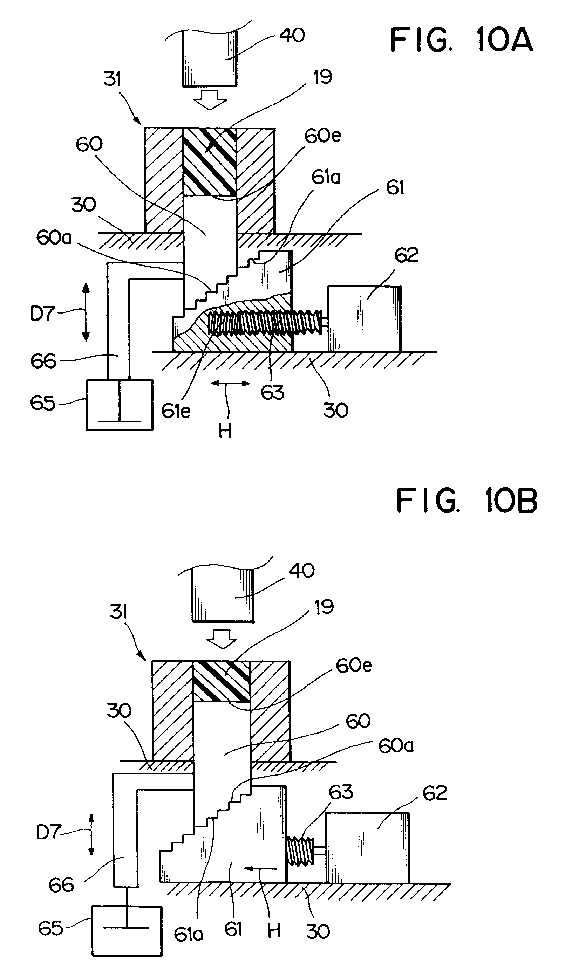

A die set for arbitrarily molding the thermosetting resin 19 to have a desired cross-sectional shape will be described with reference to Figs. 10A and 10B, which are sectional views taken along the line X - X of Fig. 8.

Referring to Fig. 10A first, a bottom block 60 forming a stepped portion 60a is incorporated in a portion corresponding to the bottom portion of the die set 31 provided on the base 30, thereby forming the bottom portion of the die set 31. An arm 66 is fixed to the bottom block 60. When the arm 66 is driven by a cylinder 65 in directions indicated by a double-headed arrow D7, the bottom block 60 can be moved in the directions indicated by the double-headed arrow D7.

A bottom block retainer 61 having a stepped portion 61a is provided under the bottom block 60 such that their stepped portions 60a and 61a can mate with each other. A screw shaft 63 is provided to threadably engage with a female threaded portion 61e formed in the bottom block retainer 61. As a motor 62 having the screw shaft 63 as the output shaft is rotated in a predetermined manner, the bottom block retainer 61 is moved in directions indicated by a double-headed arrow H in Fig. 10A.

In the above arrangement, when the punch 40 is moved from the state shown in Fig. 10A in a direction indicated by a thick arrow, the pressure is received by an upper surface 60e of the bottom block 60, so that the thermosetting resin 19 is compressed in the die set 31.

To decrease the height of the thermosetting resin 19, referring to Fig. 10B, the cylinder 65 is driven to move the bottom block 60 upward through the arm 66. Thereafter, the motor 62 having the screw shaft 63 as the output shaft is rotated in a predetermined manner to drive the bottom block retainer 61 in a direction indicated by an arrow H in Fig. 10B. Thus, the stepped portions of the bottom block 60 and the bottom block retainer 61 mate with each other at a higher position, and the upper surface 60e of the bottom block 60 is set at a higher position.

When the punch 40 is moved in a direction indicated by the thick arrow from the state shown in Fig. 10B, the pressure is received by the upper surface 60e, so that the thermosetting resin 19 is compressed in the die set 31. The completed thermosetting resin 19 has a smaller height than before.

Since the height of the thermosetting resin 19 completed through the above steps can be arbitrarily set, the volume of the thermosetting resin 19 can be arbitrarily set. As a result, a desired number of thermosetting resin members 19 can be arbitrarily prepared in units of lots of the electronic elements to be resin-packaged, thereby eliminating waste of the thermosetting resin 19. To arbitrarily prepare a desired number of thermosetting resin members 19 in units of lots is very significant since an epoxy resin cannot be reutilized once it is hardened, unlike a thermoplastic resin.

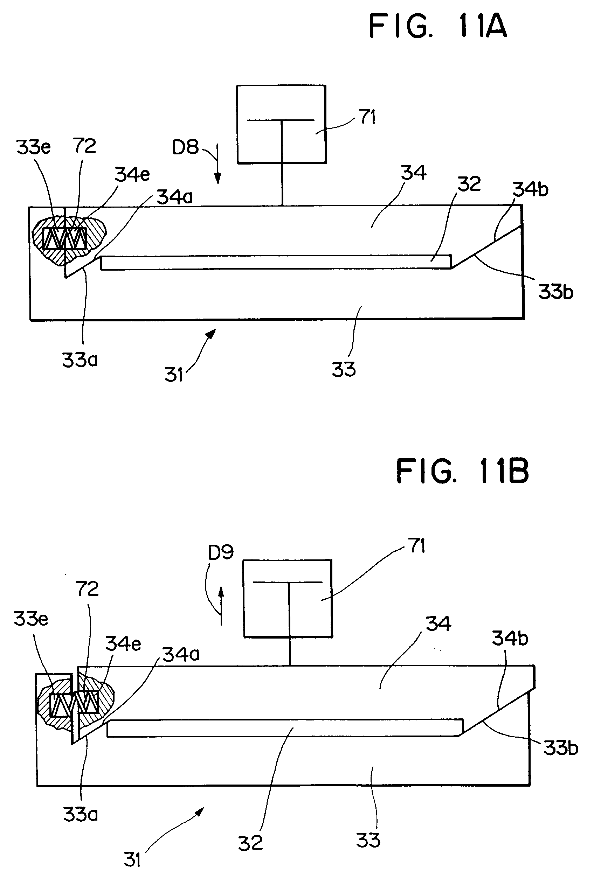

Figs. 11A and 11B are plan views of projection images of the die set 31 onto the base 30 showing the mold open state, in which Fig. 11A shows a state wherein the die set 31 is closed, and Fig. 11B shows a state wherein the die set 31 is opened. Referring to Figs. 11A and 11B, the die set 31 is constituted by the stationary die 33 and the movable die 34 to form the opening 32. The materials are uniformly supplied as described above through the opening 32 and are compressed by the punch 40, thereby obtaining the thermosetting resin 19. Inclined portions 33a and 33b, and 34a and 34b are formed respectively in the stationary die 33 and the movable die 34 to be continuous with the opening 32.

Slot facing portions 33e and 34e are respectively formed in the stationary and movable dies 33 and 34 to accommodate a compression spring 72 therein in a compressed state. By the operation of the compression spring 72, the opening 32 is widened in the widthwise direction in a parallel manner such that the inclined portions slide, as shown in Fig. 11B, so that the molded thermosetting resin can be extracted to the outside by the robot hand 55.

A cylinder 71 is connected to the movable die 34 to drive the movable die 34 in directions indicated by arrows D8 and D9 in Figs. 11A and 11B.

In the above arrangement, a molded article is obtained in the state shown in Fig. 11A against the compression force of the punch 40, and is extracted to the outside in the state shown in Fig. 11B.

When the die set 31 is constituted in this manner, a parallel guide mechanism for driving the movable die 34 parallel to the stationary die 33 becomes unnecessary, and the die set 31 can be fabricated at a lower cost. Even when a variation in size occurs in each constituent component due to thermal expansion, this variation in size can be absorbed by the inclined portions, so that size management in component formation becomes comparatively easy. Since the number of constituent components is small, disassembling operation and the like of the die set can be performed easily within a short period of time.

As described above, according to this embodiment, the thermosetting resin 19 appropriately manufactured by using the thermosetting resin manufacturing unit Q shown in Fig. 8 is sent to the press unit P through the convey unit R, is set in the runner 5 of the press unit P, and is resin-packaged by the press unit P. As a result, the efficiency of utilization of the resin for resin packaging can be greatly improved.

Since the thermosetting resin 19 having a volume optimum for resin packaging can be arbitrarily molded by using the variable-volume die set shown in Figs. 10A and 10B, a resin packaging material having optimum shape and volume can be prepared as required in units of lots of the electronic elements to be resin-packaged.

According to the arrangement described above, when a thermosetting material for resin packaging that can prevent defects, e.g., voids and chipping in the resin packaging portions, is to be prepared, waste in the material can be eliminated. Also, a thermosetting material having optimum volume and shape to cope with alteration of the type of electronic elements to be resin-packaged can be appropriately prepared. Also, a die set which can be disassembled easily, is inexpensive, and has an excellent heat stability for the purpose of molding a thermosetting material can be provided.

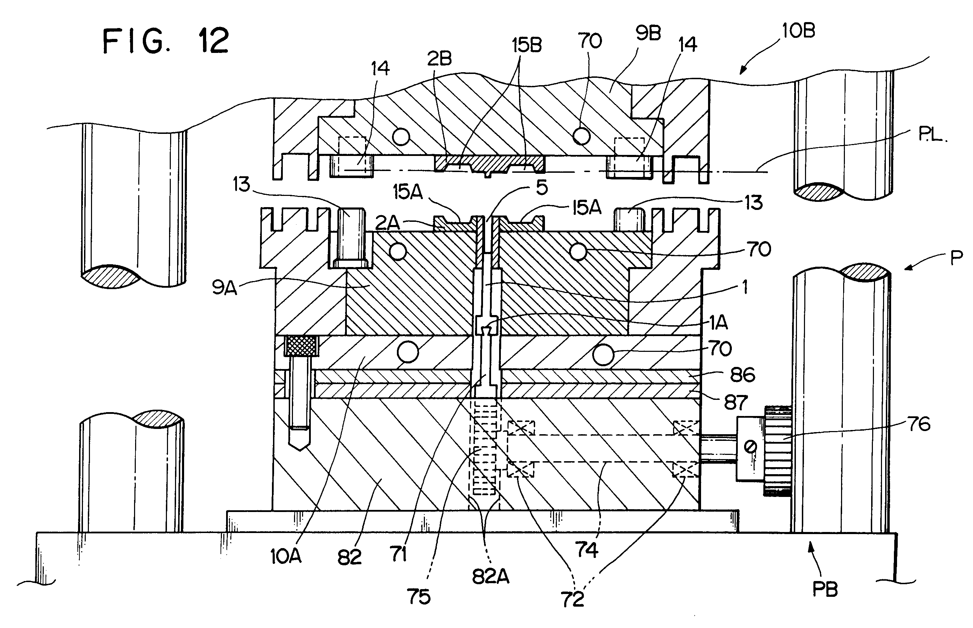

Fig. 12 is a sectional view of the main part of a resin packaging mold unit and shows an arrangement according to the third embodiment of the present invention. Referring to Fig. 12, constituent portions respectively indicated by the reference numerals each with suffix B and associated with the upper mold, and constituent portions respectively indicated by the reference numerals each with suffix A and associated with the lower mold, are provided at predetermined positions of a press unit P, as shown in Fig. 12. In this embodiment, the lower mold portion of the press unit P is moved upward toward the upper mold. The constituent portions of the upper and lower molds are separated from each other at a parting line PL formed between upper and lower cavity blocks 2B and 2A. The upper and lower springs, the upper and lower ejector pins, and the like described with reference to Fig. 1 are omitted. Referring to Fig. 12, an upper backup plate 9B that fixes the upper cavity block 2B is replaceably fixed on an upper base 10B with bolts (not shown), and a lower backup plate 9A that fixes the lower cavity block 2A is replaceably fixed on a lower base 10A.

In the mold closing state, guides 13 fixed at the four corners of the lower backup plate 9A are guided to enter bushes 14 fixed at the four corners of the upper backup plate 9B, thereby precisely positioning the lower and upper backup plates 9A with each other. As a result, high-precision positioning of the upper and lower cavity blocks 2B and 2A relative to each other is enabled.

Heaters 70 for heating the upper and lower cavities and a thermosetting resin 19 to a predetermined temperature, and a cooling water channel for cooling the thermosetting resin 19 to an extracting temperature after resin packaging, are provided to the upper and lower backup plates 9B and 9A and the lower base 10A. Thus, desired temperature control can be performed.

A mechanism for driving a movable runner 1 in a runner 5, formed at substantially the central portion of the lower cavity block 2A, in the directions indicated by the arrows F and J (refer to Fig. 1) in the above manner has a following arrangement. More specifically, a drive base 82 is provided below the lower base 10A through a heat-insulating sheet member 86 and a master die base 87. A drive runner 71 can thus be vertically moved in a guide groove 82A, indicated by a broken line in Fig. 12, which is formed in the drive base 82. A projecting portion to be inserted in a dovetail portion formed in the movable runner 1 is formed at the upper end portion of the drive runner 71, thereby enabling integral assembly of the drive runner 71 and the movable runner 1.

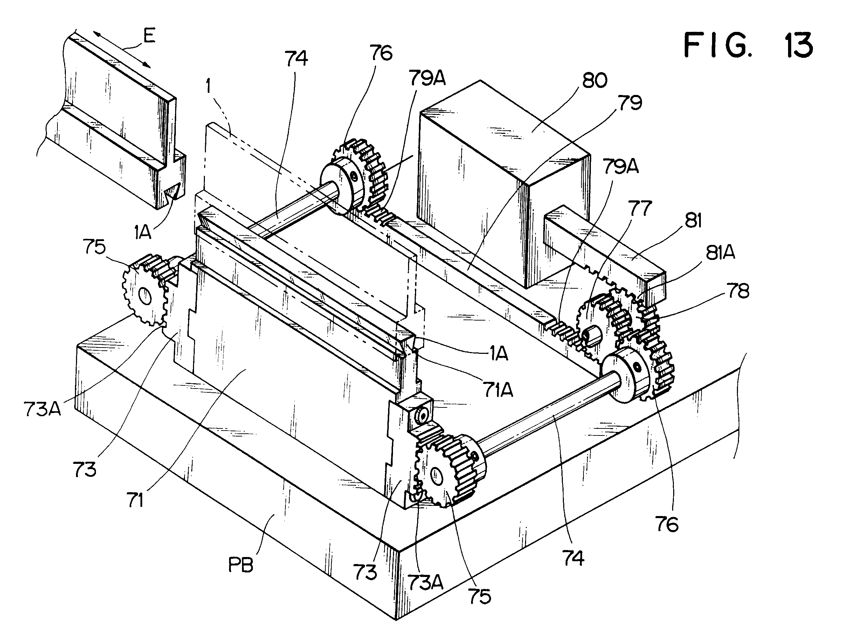

Fig. 13 is a perspective view showing the outer appearance of the drive mechanism of the drive runner 71. Referring to Figs. 12 and 13, a total of four bearings 72 are provided to the drive base 82 to pivotally support a pair of gear shafts 74. A first pinion gear 75 and a second pinion gear 76 are fixed to the two end portions of each gear shaft 74. Racks 73 forming gear teeth 73A to mesh with the corresponding first pinion gears 75 are fixed to the two side portions of the drive runner 71 which is provided to be vertically movable in the drive base 82 as described above.

A projecting portion 71A to be inserted in a dovetail groove 1A formed in the movable runner 1 in a direction indicated by an arrow E in Fig. 13 is formed at the upper end portion of the drive runner 71. Therefore, the drive runner 71 and the movable runner 1 can be integrally assembled with each other, and can withstand both the compression force and the pulling force acting during the vertical movement of the drive runner 71.

Next, referring only to Fig. 13, a third pinion gear 77 pivotally supported on the drive base 82 meshes with one second pinion gear 76. A fourth pinion gear 78, meshing with a teeth portion 81A of a rack 81 of a hydraulic cylinder 80 fixed on a base PB of the press unit P, is fixed on a shaft body that fixes the third pinion gear 77, so that the third and fourth pinion gears 77 and 78 become integral. Accordingly, a single pinion gear may be used instead of these two pinion gears if it has a wide teeth portion.

An elongated rack 79 is provided under the third pinion gear 77. The elongated rack 79 is guided to be moved parallel to the moving direction of the rack 81 of the hydraulic cylinder 80, and forms rack teeth portions 79A at its two end portions. One rack teeth portion 79A meshes with the third pinion gear 77, while the other rack teeth portion 79A meshes with the corresponding second pinion gear 76.

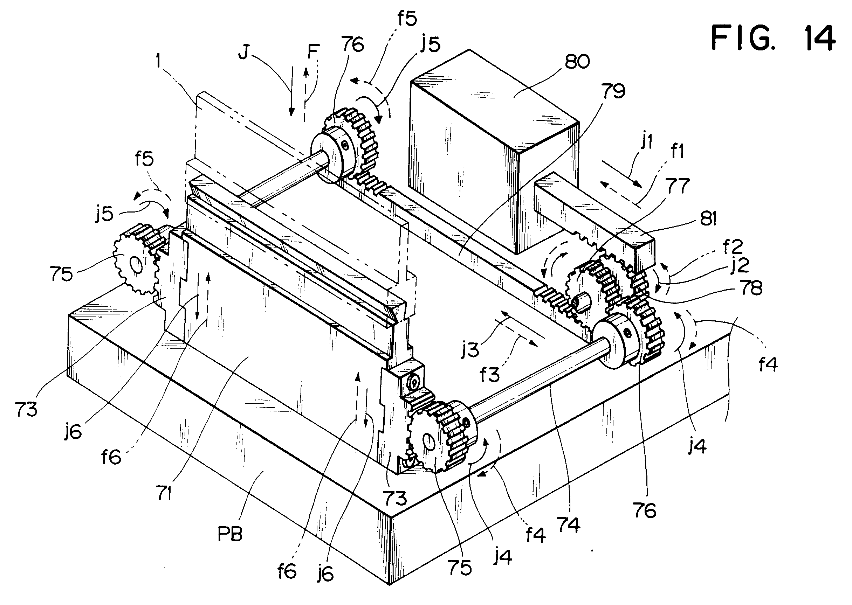

The operation of the drive mechanism of the drive runner of the above description will be described with reference to Fig. 14, which explains the operation. When the thermosetting resin 19 is flowed into the runner 5 and the lead frames 3 are set in the lower cavity block 2A, the mold is closed to complete preparation. Then, in order to drive the movable runner 1 located below in a direction indicated by a broken arrow F in Fig. 14, the hydraulic cylinder 80 drives the rack 81 to move in a direction indicated by an arrow f1.

As a result, the fourth pinion gear 78 meshing with this rack 81 is pivoted in a direction indicated by an arrow f2, and simultaneously the third pinion gear 77 is pivoted in the direction indicated by the arrow f2. Then, the second pinion gear 76 meshing with the third pinion gear 77 is pivoted in a direction indicated by an arrow f4, and simultaneously the corresponding first pinion gear 75 is pivoted in the direction indicated by the arrow f4. As a result, one rack 73 meshing with this first pinion gear 75 is moved in a direction indicated by an arrow f6.

Meanwhile, the other second pinion gear 76 meshing with the elongated rack 79, which is located under the third pinion gear 77 and meshes with the third pinion gear 77, is pivoted in a direction indicated by an arrow f5 which is opposite to the direction indicated by the arrow f4, and pivots the other first pinion gear 75 in the same direction indicated by the arrow f5, thereby driving the corresponding rack 73 in the direction indicated by the arrow f6.

As the result of the above operation, the movable runner 1 integrally provided to the drive runner 71 is moved in the direction indicated by the broken arrow F. The thermosetting resin 19 is compressed in the runner 5 and is supplied into the cavities, thereby performing resin packaging.

Subsequently, in order to drive the movable runner 1, which has been located at an upper position by the above operation, in a direction indicated by a solid arrow J in Fig. 14, the hydraulic cylinder 80 drives the rack 81 to move in a direction indicated by an arrow j1. As a result, the fourth pinion gear 78 meshing with this rack 81 is pivoted in a direction indicated by an arrow j2, and simultaneously the third pinion gear 77 is pivoted in the direction indicated by the arrow j2. The second pinion gear 76 meshing with the third pinion gear 77 is pivoted in a direction indicated by an arrow j4, and simultaneously the corresponding first pinion gear 75 is pivoted in the direction indicated by the arrow j4. As a result, the rack 73 meshing with this first pinion gear 75 is moved in a direction indicated by an arrow j6.

Meanwhile, the other second pinion gear 76 meshing with the elongated rack 79, which is located under the third pinion gear 77 and meshes with the third pinion gear 77, is pivoted in a direction indicated by an arrow j5 which is opposite to the direction indicated by the arrow j4, and pivots the other first pinion gear 75 in the same direction indicated by the arrow j5, thereby driving the corresponding rack 73 in the direction indicated by the arrow j6. As a result of the above operation, the movable runner 1 integrally provided to the drive runner 71 is moved in the direction indicated by the arrow J. Even when the movable runner 1 is driven in this manner in the direction indicated by the solid arrow J, since the clearance in the runner 5 is set to be very small, a considerably large force is required. For this reason, the dovetail groove 1A and the projecting portion 71A described above are provided.

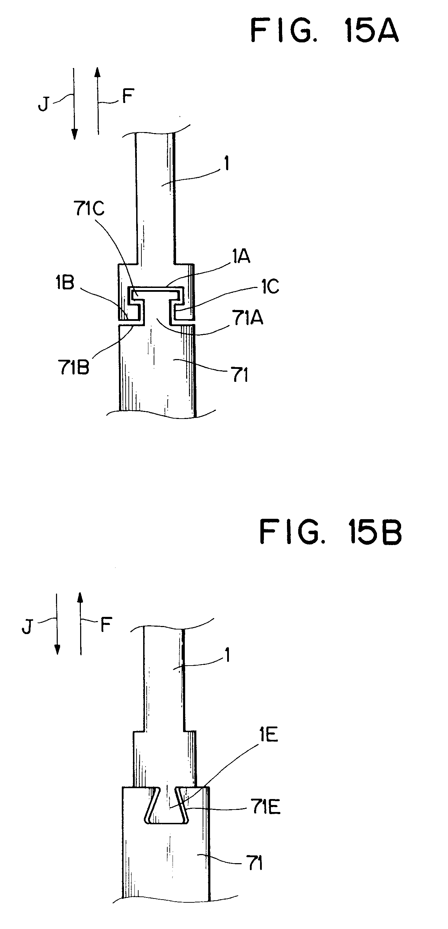

Figs. 15A and 15B are side views showing arrangements for integrally providing drive and movable runners. Referring to Fig. 15A, a dovetail groove 1A is formed in a movable runner 1 to have a substantially T-letter shape, and undercut portions 1C are formed at the right and left portions of the movable runner 1. A projecting portion 71A having portions 71C for locking the undercut portions 1C is provided to the drive runner 71. Thus, a force acting when the movable runner 1 is driven in the direction indicated by the solid arrow J, as described above, can be received by the drive runner 71. A force acting when the movable runner 1 is driven in the direction indicated by the broken arrow F can be received by stepped portions 71B and end portions 1B.

Fig. 15B is a side view showing an arrangement for integrally providing a drive runner 71 and a movable runner 1, which is opposite to the arrangement of Fig. 15A. A dovetail groove 71E is formed in the drive runner 71, and a projecting portion 1E is formed on the movable runner 1. This arrangement is also possible.

The drive and movable runners can be integrally formed in accordance with the above arrangements. When the type of electronic elements to be resin-packaged is to be altered and the upper and lower cavity blocks 2B and 2A are thus replaced, the upper and lower cavity blocks 2B and 2A are moved upward with respect to the press unit P, and the movable runner 1 is pulled out from the runner 5 and removed. Thereafter, as shown in Fig. 13, the movable runner 1 is moved in a direction indicated by a double-headed arrow E and removed from the drive runner 71. Then, the movable runner 1 matching a runner 5 having a shape suitable for the cavities to be resin-packaged is set by being moved in directions indicated by a double-headed arrow E with respect to the drive runner 71.

Subsequently, the upper and lower cavity blocks 2B and 2A to be resin-packaged are fixed to the press unit P, thus completing preparation of resin packaging of the next lot. With this arrangement, the components to be replaced are the movable runner 1 and the upper and lower backup plates 9B and 9A provided with the upper and lower cavity blocks 2B and 2A. Thus, the replacing operation becomes considerably simple, thereby enabling resin packaging of different lots.

According to the elevating mechanism constituted by the hydraulic cylinder, the respective pinion gears, and the respective racks for vertically driving the drive runner 71, as described above, the elevating mechanism can be disposed on a limited space on the base PB of the press unit P, and the heat-sensitive hydraulic cylinder can be provided at a location comparatively remote from the cavities and cavity blocks, which will be heated to a high temperature. Therefore, the adverse influence of heat is small.

The elevating mechanism for driving the movable runner 1 is not limited to one using the racks and the pinion gears, described above. An elevating mechanism which directly vertically moves the movable runner 1 with one cylinder, as described above with reference to Fig. 1, and a pantograph link-type elevating mechanism which is used in some jacks of an automobile can be used instead.

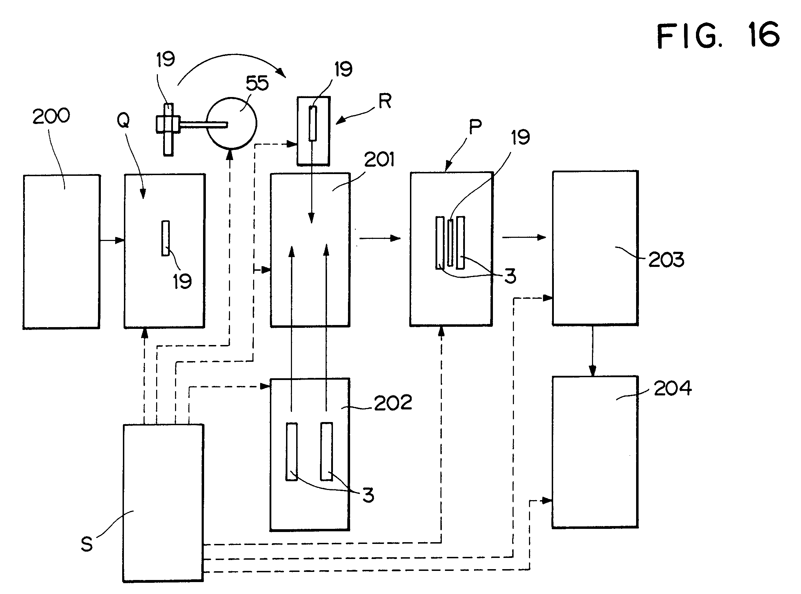

Fig. 16 is a view showing the overall arrangement of the resin packaging apparatus. Referring to Fig. 16, a material as a mixture of 70 wt% of silica and 30 wt% of a material which is obtained by mixing carbon black, a hardening promoting agent, and a mold release agent in a granular epoxy resin, is stored in a material stock section 200. The material stock section 200 can supply a predetermined amount of this mixture to the thermosetting resin material manufacturing unit Q, which is disposed at the downstream of the material stock section 200, and used for manufacturing the thermosetting resin member 19.

A robot unit 55 is disposed in the vicinity of the thermosetting resin material manufacturing unit Q. The thermosetting resin member 19 which is molded by the thermosetting resin material manufacturing unit Q to have a predetermined rectangular shape is held by the robot unit 55 and then temporarily conveyed to the convey unit R. A convey section 201 is provided in the vicinity of the convey unit R. The convey section 201 conveys the lead frames 3, supplied from a storage section 202 which stores a large number of lead frames 3 having the thermosetting resin member 19 and predetermined electronic parts mounted thereon, to the press unit P.

For example, one unit of lead frames 3 and one thermosetting resin member 19 are grouped in a set and conveyed to the press unit P by the convey section 201.

A cutting section 203 for cutting the lead frames is provided at the downstream of the press unit P. After resin packaging by the press unit P is completed, the lead frames are cut from semi-completed products, as shown in Figs. 6 and 7, and bent by the cutting section 203, thereby obtaining completed products. The cutting section 203 sends the completed products to a stocker section 204 located at the final stage.

A central control unit S connected to signal lines indicated by broken lines in Fig. 16 is connected to the respective constituent components and units described above. The respective constituent components and units are centrally controlled based on instructions sent from a controller incorporated in the central control unit S, thereby driving the series of members ranging from the hydraulic cylinder to the motor described above.

According to the arrangement described above, there is provided a resin packaging mold unit wherein the efficiency of utilization of a resin for resin packaging can be greatly improved, occurrence of defects, e.g., voids and chipping in the packaging portions can be prevented, preheating of the resin is enabled by means of molding the packaging resin rectangularly to have a wide surface area, thus preventing early wear of components associated with supply of the resin, and the number of components to be replaced for alteration of the type of electronic elements to be resin-packaged can be largely decreased, thereby shortening a time required for replacement of a mold.

As many apparently widely different embodiments of the present invention can be made without departing from the spirit and scope thereof, it is to be understood that the invention is not limited to the specific embodiments thereof except as defined in the appended claims.

## Claims

1. A resin packaging method for resin-packaging a lead frame having predetermined electronic elements mounted thereon, comprising:
the first step of preparing a thermosetting resin material molded to have a predetermined volume to substantially match an inner shape of a runner elongated in a horizontal direction;
the second step of, after mold opening, positioning and holding the lead frame on upper surface portions of a plurality of cavities, which form female portions for resin packaging at substantially axial-symmetric positions thereof with respect to a longitudinal direction of said horizontally elongated runner through gates;
the third step of flowing the thermosetting resin material into said horizontally elongated runner;
the fourth step of simultaneously filling and feeding with pressure the thermosetting resin material toward said cavities by a movable runner which is driven in said horizontally elongated runner, thereby performing resin packaging after mold closing; and
the fifth step of, after mold opening, extracting an integral product of the lead frame which has been resin-packaged.

2. A resin packaging method according to claim 1, wherein said thermosetting resin material is fed toward a convex portion which is formed above said movable runner.

3. A resin packaging apparatus for resin-packaging a lead frame having predetermined electronic elements mounted thereon, comprising:
a plurality of cavities which form female portions for resin packaging at substantially axial-symmetric positions thereof with respect to a longitudinal direction of a horizontally elongated runner through gates; and
a movable runner for simultaneously filling and feeding with pressure a thermosetting resin material, pre-molded to substantially match an inner shape of said horizontally elongated runner, toward said cavities through said horizontally elongated runner.

4. A resin packaging apparatus according to claim 3, wherein said thermosetting resin material is fed toward convex portion which is formed above said horizontally elongated runner.

5. A resin packaging method for resin-packaging a lead frame having predetermined electronic elements mounted thereon, comprising:
in order to prepare a thermosetting resin material molded to have a predetermined volume and a predetermined shape to substantially match an inner shape of a horizontally elongated runner,
the first step of supplying a granular material substantially uniformly toward a die set having a hollow portion substantially matching said inner shape of said horizontally elongated runner;
the second step of compression-molding the material, supplied into said die set, with a punch, thereby obtaining the thermosetting resin material;
the third step of extracting the thermosetting resin material, after said die set is mold-opened, and flowing the thermosetting resin material into said horizontally elongated runner;
the fourth step of simultaneously filling and feeding with pressure the thermosetting resin material toward cavities by a movable runner which is driven in said horizontally elongated runner, thereby performing resin packaging after a press unit for resin packaging performs mold closing; and
the fifth step of extracting an integral product, which has been resin-packaged, after said press unit performs mold opening, to outside said mold.

6. The method according to claim 3, wherein the preparatory step of enabling change in volume of the hollow portion of said die set is provided before the first step.

7. A resin packaging apparatus for resin-packaging a lead frame having predetermined electronic elements mounted thereon, comprising:
in order to prepare a thermosetting resin material molded to have a predetermined volume and a predetermined shape to substantially match an inner shape of a horizontally elongated runner,
material supplying means for supplying a granular material substantially uniformly toward a die set having a hollow portion substantially matching said inner shape of said horizontally elongated runner;
compression molding means for compression-molding the material, supplied into said die set, with a punch, thereby obtaining the thermosetting resin material;
conveying means for extracting the thermosetting resin material, after said die set is mold-opened, and conveying and flowing the thermosetting resin material into said horizontally elongated runner;
a press unit for simultaneously filling and feeding with pressure the thermosetting resin material toward cavities by a movable runner which is driven in said horizontally elongated runner, thereby performing resin packaging after said press unit for resin packaging performs mold closing; and
extracting means for extracting an integral product, which has been resin-packaged, after said press unit performs mold opening, to outside said mold.

8. The apparatus according to claim 5, wherein die set hollow portion changing means for enabling change in volume of the hollow portion of said die set is provided to said die set.

9. The apparatus according to claim 5, wherein die set bottom face changing means for changing a height of a bottom surface of the hollow portion is provided to said die set in order to enable change in volume of the hollow portion of said die set.

10. The apparatus according to claim 5, wherein said die set is constituted by a stationary die and a movable die, the hollow portion is defined by said stationary and movable dies, and inclined surfaces continuous to the hollow portion are formed on mating surfaces of said stationary and movable dies.

11. A resin packaging mold unit for resin-packaging a lead frame having predetermined electronic elements mounted thereon, comprising:
a press unit main body;
a cavity block which is fixed to said press unit main body to be easily detachable and forms a plurality of cavities for resin packaging at substantially axial-symmetric positions with respect to an elongated direction of a horizontally elongated runner through gates;
a movable runner for supplying a thermosetting resin material, pre-molded to have a shape substantially matching an inner circumferential shape of said horizontally elongated runner, into said cavities;
a drive runner, disposed on said press unit main body to be movable in a parallel manner in order to reciprocally drive said movable runner, and having an engaging portion for allowing one-step insertion of said movable runner therein, thereby detachably fixing said movable runner therein; and
drive means, disposed on said press unit main body, for moving said drive runner in the parallel manner.

12. A resin packaging mold unit for resin-packaging a lead frame having predetermined electronic elements mounted thereon, comprising:
a press unit main body having a stationary base and a movable base;
a first cavity block which is fixed to said movable base to be easily detachable and forms a plurality of cavities for resin packaging at substantially axial-symmetric positions with respect to an elongated direction of a horizontally elongated runner through gates;
a second cavity block which is fixed to said stationary base to be easily detachable and forms a plurality of cavities for resin packaging;
a movable runner for supplying a thermosetting resin material, pre-molded to have a shape substantially matching an inner circumferential shape of said horizontally elongated runner, into said cavities;
a drive runner, disposed on said press unit main body to be movable in a parallel manner in order to move said movable runner, and having an engaging portion for allowing insertion of said movable runner therein in a longitudinal direction thereof, thereby detachably fixing said movable runner therein; and
drive means, disposed on said movable base of said press unit main body, for moving said drive runner in the parallel manner.

13. The mold unit according to claim 10, wherein said drive means comprises a hydraulic cylinder having a reciprocally movable rack, a pair of pinion gears meshing with said reciprocally movable rack and pivotally supported to pivot in opposite directions on said movable base, and a pair of racks meshing with said pinion gears and fixed at two end portions of said drive runner.

14. A method of packaging a circuit board having electronic elements mounted thereon, comprising:
providing a mould (2A; 2B) having at least one chamber for receiving a circuit board and an elongate RAM (1) movable within an elongate supply aperture (5) common to cavities in the surface of said chamber for receiving said electronic elements;
opening the mould;
positioning and holding the circuit board within the chamber with said elements located within said cavities;
feeding thermosetting plastics material into said elongate supply aperture;
closing said mould feeding the thermosetting plastics material into said cavities by way of said elongate RAM thereby encasing said elements in said plastics material; and
opening the mould to extract an integral product of the circuit board.

15. A plastics moulding apparatus for packaging a circuit board having electronic elements mounted thereon, comprising:
a mould (2A, 2B) having at least one chamber for receiving a circuit board, the surface of said chamber having a plurality of cavities for receiving said elements;
an elongate supply aperture (5) common to said cavities;
and an elongate RAM (1) for driving thermosetting plastics material through said supply aperture simultaneously into said cavities.
